# EUROPEAN PATENT SPECIFICATION

(11) **EP 3 644 358 B1**
(45) Date of publication and mention of the grant of the patent: **13.10.2021**
(21) Application number: 18202517.1
(22) Date of filing: 25.10.2018
(51) Int. Cl.: H01L 23/498

(54) **POWER SEMICONDUCTOR MODULE ARRANGEMENT INCLUDING A CONTACT ELEMENT**
LEISTUNGSHALBLEITERMODULANORDNUNG MIT EINEM KONTAKTELEMENT
AGENCEMENT D'UN MODULE SEMICONDUCTEUR DE PUISSANCE COMPRENANT UN ÉLÉMENT DE CONTACT

(43) Date of publication of application: 29.04.2020
(73) Proprietor: Infineon Technologies AG, 85579 Neubiberg (DE)
(72) Inventor: Nottelmann, Regina, 59505 Bad Sassendorf (DE); Müller, Christian Robert, 97421 Schweinfurt (DE); Nomann, Marianna, 59602 Ruethen (DE)
(74) Representative: Westphal, Mussgnug & Partner, Patentanwälte mbB

(56) References cited:
- EP-A2- 0 772 235
- DE-U1- 8 700 978
- JP-A- H02 178 954
- US-A1- 2012 077 357

## Description

### TECHNICAL FIELD

The instant disclosure relates to a power semiconductor module arrangement including a contact element, and to a contact element for use in a power semiconductor module arrangement.

### BACKGROUND

DE8700978U1 discloses a power semiconductor module arrangement. Power semiconductor module arrangements often include a substrate within a housing. The substrate usually comprises a substrate layer (e.g., a ceramic layer), a first metallization layer deposited on a first side of the substrate layer and, optionally, a second metallization layer deposited on a second side of the substrate layer. A semiconductor arrangement including one or more controllable semiconductor elements (e.g., two IGBTs in a half-bridge configuration) may be arranged on the substrate. One or more contact elements, which allow for contacting such a semiconductor arrangement from outside the housing, are usually provided. Power semiconductor modules are known, where the contact elements are arranged on the substrate and protrude in a direction that is essentially perpendicular to the main surface of the substrate through a cover of the housing. The section of the contact elements which protrudes out of the housing may be mechanically and electrically coupled to a printed circuit board. Usually, the printed circuit board comprises through holes and each contact element is inserted through one of the through holes. Many applications require the semiconductor arrangement to be as symmetric as possible and to be of low inductance.

There is a need for a power semiconductor module arrangement that provides an increased symmetry, and a low inductance.

### SUMMARY

A power semiconductor module arrangement includes a semiconductor substrate including a dielectric insulation layer, and a first metallization layer arranged on a first side of the dielectric insulation layer, at least one semiconductor body mounted on a first surface of the first metallization layer which faces away from the dielectric insulation layer, and at least one contact element that is mechanically and electrically connected to the first metallization layer, wherein each of the contact elements extends from the first metallization layer in a vertical direction perpendicular to the first surface. Each contact element includes a first electrically conducting part, a second electrically conducting part, and an electrically insulating layer arranged between the first part and the second part, thereby interconnecting the first part and the second part and preventing an electrical connection between the first part and the second part. Each contact element has a first length in the vertical direction that is large as compared to its dimensions in a first and second horizontal direction perpendicular to the vertical direction. The electrically insulating layer of a contact element extends between the respective first part and second part in the vertical direction.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a cross-sectional view of another power semiconductor module arrangement.
Figure 3, including Figures 3A and 3B, schematically illustrates a pressfit connection.
Figure 4 is a cross-sectional view of an exemplary power semiconductor module arrangement comprising contact elements.
Figure 5 is a cross-sectional view of another exemplary power semiconductor module arrangement comprising contact elements.
Figure 6 is a cross-sectional view of the upper part of a contact element.
Figure 7 is a cross-sectional view of the upper part of a contact element.
Figure 8 schematically illustrates a lower part of one of the contact elements of the power semiconductor arrangement of Figure 6 or 7.
Figure 9, including Figures 9A and 9B, schematically illustrates a spatial view of a two-piece contact element.
Figure 10 schematically illustrates a cross-sectional view of a two-piece contact element.
Figure 11 schematically illustrates a cross-sectional view of a lower part of a contact element.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". A semiconductor body as described herein may be made from (doped) semiconductor material and may be a semiconductor chip or may be included in a semiconductor chip. A semiconductor body has electrically connecting pads and includes at least one semiconductor element with electrodes.

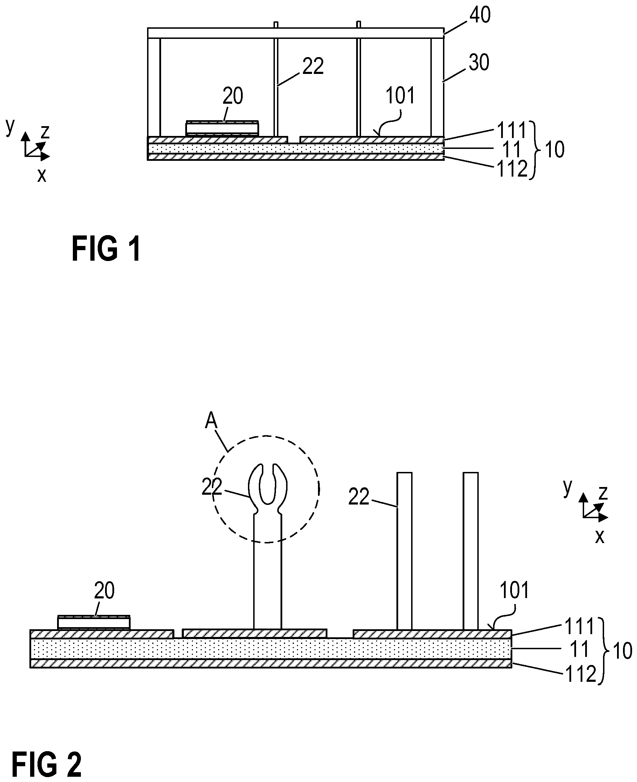

Referring to Figure 1, a conventional power semiconductor module arrangement is illustrated. The power semiconductor module arrangement includes a substrate 10. The substrate 10 includes a dielectric insulation layer 11, a (structured) first metallization layer 111 arranged on a first side of the dielectric insulation layer 11, and a second metallization layer 112 arranged on a second side of the dielectric insulation layer 11. The dielectric insulation layer 11 is disposed between the first and the second metallization layer 111, 112. The substrate 10 comprising a first and a second metallization layer 111, 112, however, is only an example. Other substrates are known that only comprise a first metallization layer 111 but no second metallization layer 112. Other substrates are known, which comprise a plurality of dielectric insulation layers and metallization layers stacked alternatingly on top of each other, thereby forming a multi-layer substrate.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. The substrate 10 may be, e.g., a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., Si₂O, Al₂O₃, AlN, or BrN and may have a diameter of between about 1µm and about 50µm. The first metallization layer 111 of an IMS may be a comparably thin copper layer (e.g., thickness of between 35µm and 140µm), and the second metallization layer 112 may be a comparably thick aluminium or copper layer (e.g., thickness of between 0.6mm and 2.0mm), for example. The substrate 10, however, may also be a conventional printed circuit board (PCB) having a non-ceramic dielectric insulation layer 11. For instance, a non-ceramic dielectric insulation layer 11 may consist of or include a cured resin.

One or more semiconductor bodies 20 may be arranged on the substrate 10. In particular, the one or more semiconductor bodies 20 may be arranged on a first surface 101 of the first metallization layer 111 which faces away from the dielectric insulation layer 11. Each of the semiconductor bodies 20 arranged on the semiconductor substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable semiconductor element.

The one or more semiconductor bodies 20 may form a semiconductor arrangement on the substrate 10. In Figure 1, only one semiconductor body 20 is exemplarily illustrated. The one or more semiconductor bodies 20 may be electrically and mechanically connected to the substrate 10 by an electrically conductive connection layer 21. Such an electrically conductive connection layer 21 may be a solder layer, a layer of an electrically conductive adhesive, or a layer of a sintered metal powder (e.g., a sintered silver powder), for example. The connection between the semiconductor bodies 20 and the substrate 10 may also be a welded connection, for example.

The second metallization layer 112 of the semiconductor substrate 10 in Figure 1 is a continuous layer, while the first metallization layer 111 is a structured layer. The second metallization layer 112 being a continuous layer, however, is only an example. The second metallization layer 112 can also be a structured layer. "Structured layer" in this context means that the first metallization layer 111 is not a continuous layer, but includes recesses between different sections of the layer. Such a recess is schematically illustrated in Figure 1. The first metallization layer 111 in this example includes two different sections. Different semiconductor bodies 20 may be mounted to the same or to different sections of the first metallization layer 111. There may also be sections of the first metallization layer 111 with no semiconductor bodies 20 mounted thereon. Different sections of the first metallization layer 111 have no direct electrical connection, but may be electrically connected to one or more other sections by means of electrically conducting elements such as bonding wires, for example.

The substrate 10 may be arranged in a housing to form a power semiconductor module. The housing may include sidewalls 30 and a lid 40, as is schematically illustrated in Figure 1. The substrate 10 may form a bottom of the housing. However, it is also possible that the housing further comprises a bottom. According to another example, the substrate 10 is mounted on a base plate (not illustrated) which is arranged within the housing or which may form a bottom of the housing.

In order to facilitate an electrical connection between different sections of the first metallization layer 111, between different semiconductor bodies 20 and/or between any other elements and components arranged on the first metallization layer 111, as well as with external components outside the housing (e.g., a printed circuit board), the power semiconductor module arrangement includes at least one contact element 22. The at least one contact element 22 is arranged on the substrate 10. Generally, the at least one contact element 22 is arranged on the same surface (here: first surface 101 of the first metallization layer 111) as the semiconductor bodies 20. Each of the at least one contact element 22 may be a pin or a wire, for example. The contact element 22 may consist of or include an electrically conductive material such as a metal or metal alloy. For example, the contact element 22 may consist of or include copper. The contact element 22 is connected to the substrate 10 by means of a connecting element (not illustrated). The connecting element may comprise a solder layer, an electrically conductive adhesive, a layer of a sintered metal powder, a welding seam, or a sleeve or rivet, for example. Generally speaking, the connecting element is configured to attach and electrically connect the contact element 22 to the substrate 10.

The contact element 22 is coupled to the substrate 10 with a first end and protrudes from the substrate 10 through the inside of the housing and through an opening in the cover 40 of the housing (if applicable) such that a second end of the contact element 22 protrudes to the outside of the housing. In this way, the contact element 22 may be electrically contacted from the outside of the housing. For example, the second ends of the contact elements 22 may be connected to a printed circuit board (not illustrated in Figure 1).

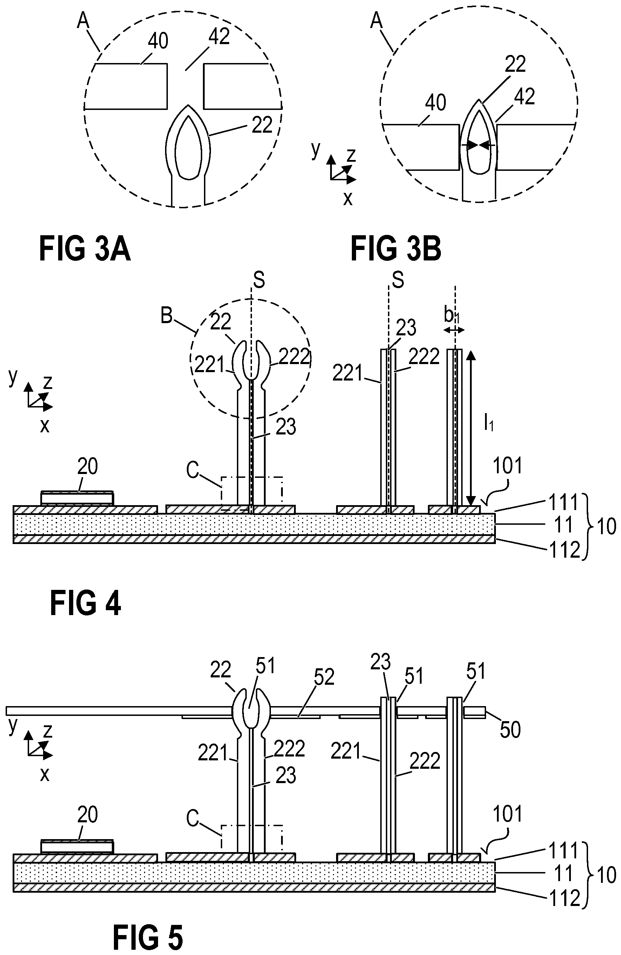

Now referring to Figure 2, a semiconductor substrate 10 with a semiconductor body 20 and contact elements 22 arranged thereon is exemplarily illustrated. The contact elements 22, for example, may comprise simple pins or wires, as is illustrated on the right side of Figure 2. According to another example, the contact elements 22 include pressfit pins at their second ends, which face away from the substrate 10. The second end of such a contact element 22 is exemplarily illustrated in Figure 3, where Figure 3A schematically illustrates a pressfit pin and the corresponding counterpart (e.g., the opening 42 within a cover 40 of the housing, or a through hole in a printed circuit board) in a non-assembled state, and Figure 3B schematically illustrates the press-fit pin and the corresponding counterpart in an assembled state. The openings 42 or through holes may form an appropriate counterpart for the pressfit pin of the contact element 22. While not connected to the counterpart, a pressfit pin has a larger length than its counterpart. The length of the pressfit pin is a length in a horizontal direction x, z parallel to the top surface 101 of the semiconductor substrate 10. During the press-in process, the pressfit pin is pushed into the counterpart. This results in a plastic deformation of the pressfit pin. When inserted into the counterpart, the length of the pressfit pin is reduced. Only small insertion forces are generally necessary with high holding forces at the same time. The pressfit pin and the counterpart, after inserting the pressfit pin, are firmly attached to each other. The reduced length of the pressfit pin results in a force which counteracts the compression of the pressfit pin. The contact elements 22, therefore, may not be easily detached from the openings 42. However, pressfit connections formed between the contact elements 22 and the corresponding openings 42 are only an example. Any other suitable connections between the contact elements 22 and the cover 40 are also possible. For example, the second ends of the contact elements 22 may be soldered into the through holes.

For many applications, it is desirable for the semiconductor arrangement formed by the semiconductor bodies 20, the first metallization layer 111, and the contact elements 22, to be as symmetric as possible and to be of low inductance. A symmetry of the semiconductor arrangement may be achieved, for example, by using identical semiconductor bodies 20 with identical electrical properties, and by ensuring that the electrical paths that are formed by the first metallization layer 111 have identical or at least very similar electrical properties. This can be reached, e.g., by forming different sections of the first metallization layer 111 with identical dimensions, identical resistances, and/or identical materials.

Now referring to Figure 4, an exemplary embodiment of a power semiconductor module arrangement according to the present invention is schematically illustrated. The power semiconductor module arrangement essentially corresponds to the power semiconductor arrangements as described with respect to Figures 1 and 2 above. In the example of Figure 4, however, each of the contact elements 22 comprises a first part 221 and a second part 222 to further increase the symmetry of the semiconductor arrangement. The first part 221 of a contact element 22 comprises an electrically conducting material, and the second part 222 comprises an electrically conducting material. The first and second parts 221, 222 may consist of or include one of the following materials: copper; a copper alloy; aluminum; an aluminum alloy; any other metal or alloy that remains solid during the operation of the power semiconductor module arrangement. A layer of electrically insulating material 23 is arranged between the first electrically conducting part 221 and the second electrically conducting part 222. On the one hand, the layer of electrically insulating material 23 interconnects the first part 221 and the second part 222. On the other hand, the layer of electrically insulating material 23 prevents an electrical connection between the first part 221 and the second part 222. For example, the layer of electrically insulating material 23 may comprise a ceramic material, a plastic material, a cured resin, or an adhesive. The layer of electrically insulating material 23 may be formed using similar processes as are used to form the dielectric insulation layer 11 of a substrate 10, for example. According to one example, the first part 221 comprises a metal sheet, e.g., a copper sheet. A thin plastic coating may be applied to this metal sheet before applying a second metal sheet (e.g., copper sheet), thereby forming a laminate structure.

A first part 221 of a contact element 22 may be electrically connected to one of the sections of the first metallization layer 111. The second part 222 of the same contact element 22 may be electrically connected to another one of the sections of the first metallization layer 111. In this way, a single contact element 22 may be used to electrically contact two different sections of the first metallization layer 111 and, therefore, two different potentials of the semiconductor arrangement.

According to one example, at least one of the semiconductor bodies 20 comprises a gate electrode, an emitter electrode, and a collector electrode. The gate electrode may be electrically coupled to a first section, the emitter electrode may be coupled to a second section, and the collector electrode may be coupled to a third section of the first metallization layer 111. A single contact element 22, for example, may be used to contact the gate electrode and the emitter electrode of the semiconductor body 20 by electrically connecting the first part 221 to the first section, and the second part 222 to the second section of the first metallization layer 111. This allows a high symmetry of the electrical paths of the power semiconductor module arrangement.

Now referring to Figure 5, a power semiconductor module arrangement may further include a printed circuit board 50. The printed circuit board 50 may comprise through holes 51. The contact elements 22 may extend from the substrate 10 towards the printed circuit board 50 and through the through holes 51. The printed circuit board 50 may further comprise a conducting track 52. The conducting track 52 may be a structured layer, similar to the first metallization layer 111 of the substrate 10. The first part 221 of a contact element 22 may be electrically coupled to a first section of the conducting track 52, and the second part 222 of the same contact element 22 may be electrically coupled to another section of the conducting track 52.

A contact element 22 may be electrically coupled to one or more other contact elements 22 by means of one or more conducting tracks 52. In this way, an electrical connection may be provided between different sections of the first metallization layer 111, between different semiconductor bodies 20, and/or between any other components arranged on the substrate 10.

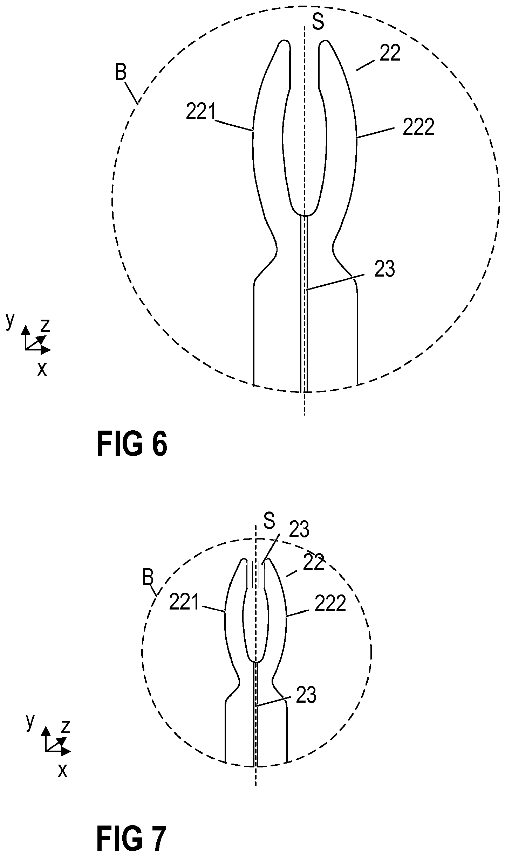

The contact elements 22 may be soldered to the printed circuit board 50, for example. According to another example, a contact element 22 may comprise a pressfit pin at its second end that may be inserted into one of the through holes 51 and may form a pressfit connection with the respective through hole 51. The second end of such a pressfit pin is exemplarily illustrated in Figure 6. In Figure 3, a pressfit pin has been illustrated which comprises a bottleneck or eye of a needle. That is, the two legs of the pressfit pin are permanently connected to each other at a lower end as well as at an upper end. In this way, however, an electrical connection is provided at the upper end of the legs. The pressfit pin that is exemplarily illustrated in Figure 6, therefore, comprises two legs that are not permanently connected to each other at their upper end. The first part 221 and the second part 222, therefore, form a fork-like structure and remain electrically isolated from each other. However, during the press-in process, the two legs of the pressfit pin are pressed towards each other. Therefore, there is a risk that the first and second part 221, 222 touch each other after the press-in process. Therefore, as is illustrated in Figure 7, the electrically insulating layer 23 may also be arranged at the upper end of the legs of the pressfit pin. This prevents the first and second part 221, 222 from touching each other even after pressing the contact element 22 into the through hole 51. According to another example (not illustrated), the legs of the pressfit pin may be permanently connected to each other, thereby forming a bottleneck or eye of a needle, similar to the pressfit pin of Figure 3, with the electrically insulating layer 23 arranged between the first part 221 and the second part 222.

The electrically insulating layer 23 may be a single continuous layer. According to another example (see, e.g., Figure 7), the electrically insulating layer 23 may comprise different sections not directly connected to each other.

As can be seen in Figures 4 and 5, the contact elements 22 have a first length l₁ in a vertical direction y. The vertical direction y is a direction perpendicular to the first surface of the first metallization layer 111. This first length l₁ is substantially greater than the dimensions bi, w₁ of the contact element 22 in a first and a second horizontal direction x, z, wherein the vertical direction y is perpendicular to both the first and the second horizontal direction x, z. The first horizontal direction x is further perpendicular to the second horizontal direction z. For example, the first length l₁ may be at least ten times, or at least fifty times a breadth bi or width w₁ of the contact element 22 in the horizontal directions x, z. That is, the contact element 22 is an elongated element extending essentially in the vertical direction y.

The first part 221 and the second part 222 may have an electrically symmetric design. An electrically symmetric design of the first and second part 221, 222 provides identical voltage and current transfers over the respective parts 221, 222 so that, for example, identical synchronous voltage impulses input at one end of the parts 221, 222 appear at the same time and in the same shape at the other end of the parts 221, 222. For example, the first part 221 and the second part 222 may exhibit at least one of identical ohmic behaviors, identical inductive behaviors, and identical capacitive behaviors. This may be achieved, e.g., if the first part 221 and the second part 222 are formed with identical lengths li, identical breadths bi, identical widths w₁, identical cross sectional areas, and identical materials. According to one example, each of the contact elements 22 is symmetrical along a symmetry axis or symmetry plane S, wherein the symmetry axis or symmetry plane S runs through the electrically insulating layer 23.

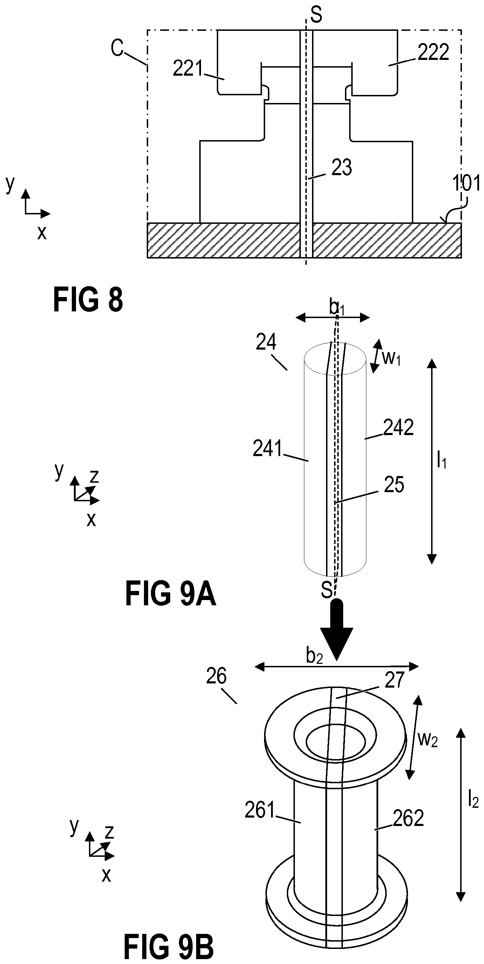

Now referring to Figure 8, an exemplary shape of a lower part of a contact element 22 is schematically illustrated. For example, the contact element 22 may have a first breadth bi in the first horizontal direction x. However, in a lower part of the contact element 22, that is, the end which is connected to the first metallization layer 111, the breadth may be increased to an increased breadth b₂. In this way, the surface area of the contact element 22 is increased in the lower part which makes it easier to connect the contact element 22 to the substrate 10. For example, it may be easier to apply a solder paste if the surface area is greater. In the example illustrated in Figure 8, the first end of the contact element 22 may be shaped balcony-like in order to provide an increased surface area. Other shapes, however, are also possible.

According to another example, the contact element 22 may be a two-piece element. This is exemplary illustrated in Figure 9. Figure 9A illustrates a first piece 24 and Figure 9B illustrates a corresponding second piece 26. The first piece 24 may comprise a wire or pin, for example. The first piece 24 comprises a first part 241 and a second part 242 with an electrically insulating layer 25 arranged between the first and second part 241, 242. The second piece 26 may comprise a tubular part (such as, e.g., a hollow bushing) that is configured to fit over and encompass a first end of the first piece 24. This means that a first end of the first piece 24 may be inserted into the second piece 26. The second piece 26 also comprises a first part 261 and a second part 262 with an electrically insulating layer 27 arranged therebetween. When the first piece 24 is inserted into the second piece 26, the first part 241 of the first piece 24 may be electrically connected to the first part 261 of the second piece 26, and the second part 242 of the first piece 24 may be electrically connected to the second part 262 of the second piece 26. On the other hand, the first part 241 of the first piece 24 may be electrically insulated from the second part 262 of the second piece 26, and the second part 242 of the first piece 24 may be electrically insulated from the first part 261 of the second piece 26. The second piece 26 may be mounted to the substrate 10, e.g., by means of soldering, sintering, gluing, or welding. It is, however, also possible, that the first piece 24 at its lower end comprises a tubular part and the second piece 26 comprises a wire or pin that is inserted into the tubular part of the first piece 24. The second piece 26 may have a length l₂ in the vertical direction y, and a breadth b₂ and width w₂ in the first and second horizontal directions x, z. The length l₂ of the second piece 26 may be less than the length l₁ of the first piece 24. According to one example, the first piece 24 and the second piece 26 may form a pressfit connection.

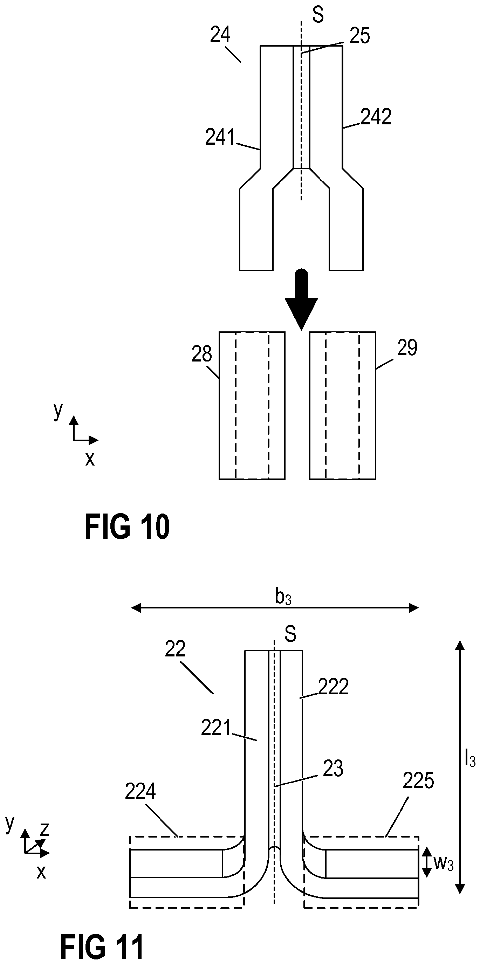

Now referring to Figure 10, the contact element 22 may comprise three pieces 24, 28, 29. The second and third pieces 28, 29 may essentially correspond to the second piece 26 that has been described with respect to Figure 9 above. However, the second and third piece 28, 29 may only comprise one part and no electrically insulating layer. The first piece 24 may be similar to the first piece 24 illustrated in Figure 9A. However, at a lower end, there may be no electrically insulating layer 25 between the first part 241 and the second part 242. At the lower end, the first part 241 and the second part 242 may be bent apart to a certain degree, and each of the first part 241 and the second part 242 may be inserted in a different one of the second piece 28 and the third piece 29. In Figure 10, the first, second and third piece 24, 28, 29 are illustrated two-dimensionally. The dashed lines in Figure 10 indicate an inner diameter of the tubular part into which the first part 241 and the second part 242 may be inserted.

Now referring to Figure 11, the lower ends of the first part 221 and the second part 222 of the contact element 22 may comprise flaps 224, 224 that are bent to extend perpendicular to the vertical direction y. Similar to the embodiment that has been described with respect to Figure 8 above, the flaps 224, 224 provide an increased surface area. The contact element 22 of Figure 11, therefore, may be easily connected to the substrate 10. The flaps 224, 224 may be bonded, soldered, glued, or welded to the substrate 10, for example.

Using a contact element having a first part 221 and a second part 222, may increase the symmetry of the semiconductor arrangement. Further, the area that is needed for arranging the contact elements 22 on the substrate 10 may be decreased, thereby increasing the remaining area.

## Claims

1. A power semiconductor module arrangement comprising:
a semiconductor substrate (10) comprising a dielectric insulation layer (11), and a first metallization layer (111) arranged on a first side of the dielectric insulation layer (11);
at least one semiconductor body (20) mounted on a first surface (101) of the first metallization layer (111) which faces away from the dielectric insulation layer (11);
at least one contact element (22) that is mechanically and electrically connected to the first metallization layer (111), wherein each of the contact elements (22) extends from the first metallization layer (111) in a vertical direction (y) perpendicular to the first surface (101),
characteriszed in that
each contact element (22) comprises a first electrically conducting part (221), a second electrically conducting part (222), and an electrically insulating layer (23) arranged between the first part (221) and the second part (222), thereby interconnecting the first part (221) and the second part (222) and preventing an electrical connection between the first part (221) and the second part (222),
each contact element (22) has a first length (l₁) in the vertical direction (y) that is large as compared to its dimensions (bₙ, wₙ) in a first and second horizontal direction (x, z) perpendicular to the vertical direction (y); and
the electrically insulating layer (23) of a contact element (22) extends between the respective first part (221) and second part (222) in the vertical direction (y).

2. The power semiconductor module arrangement of claim 1, wherein
the first metallization layer (111) is a structured layer, comprising at least two sections, wherein a gap is formed between two neighboring sections such that a direct electrical contact between different sections is prevented; and
the first part (221) of a contact element (22) is electrically coupled to a different section of the first metallization layer (111) than the second part (222) of the same contact element (22).

3. The power semiconductor module arrangement of claim 1 or 2, wherein the first part (221) of a contact element (22), and the second part (222) of the same contact element (22) exhibit at least one of identical ohmic behaviors, identical inductive behaviors, and identical capacitive behaviors.

4. The power semiconductor module arrangement of any of claims 1 to 3, wherein the first part (221) of a contact element (22), and the second part (222) of the same contact element (22) comprise identical dimensions, identical cross sectional areas, and identical materials.

5. The power semiconductor module arrangement of any of claims 1 to 4, further comprising a printed circuit board (50), wherein
the printed circuit board (50) comprises through holes (51); and
the contact elements (22) are inserted into the through holes (51) of the printed circuit board (50).

6. The power semiconductor module arrangement of claim 5, wherein
the printed circuit board (50) comprises a conducting track (52), the conducting track (52) comprising at least two sections that are electrically insulated from each other; and
the first part (221) of a contact element (22) is electrically coupled to a different section of the conducting track (52) than the second part (222) of the same contact element (22).

7. The power semiconductor module arrangement of any of claims 1 to 6, wherein each of the plurality of contact elements (22) has a round or an angular cross-section.

8. The power semiconductor module arrangement of claim 7, wherein at least one of the plurality of contact elements (22) comprises a first and a second piece (24, 26), the first piece (26) comprising a tubular part that at least partly encircles the second piece (24), and wherein
a first part (261) of the first piece (26) is in electric contact with a first part (241) of the second piece (24); and
a second part (262) of the first piece (26) is in electric contact with a second part (242) of the second piece (24).

9. The power semiconductor module arrangement of any of the preceding claims, wherein
at least one of the plurality of semiconductor bodies (20) comprises a gate electrode and an emitter electrode; and
at least one of the plurality of contact elements (22) is coupled to the gate electrode of the semiconductor body (20) with its first part (221) and to the emitter electrode with its second part (222).

10. The power semiconductor module arrangement of any of the preceding claims, wherein the contact element (22) comprises at least one of a pin, a wire, a tubular part, a sleeve, and a pressfit pin.

11. The power semiconductor module arrangement of any of the preceding claims, further comprising a connection layer between the contact element (22) and the first metallization layer (111).

12. The power semiconductor module arrangement of claim 11, wherein the connection layer comprises at least one of
a solder layer;
an electrically conductive adhesive;
a layer of a sintered metal powder; and
a welding seam.

## Patentansprüche

1. Leistungshalbleitermodulanordnung, umfassend:
ein Halbleitersubstrat (10), das eine dielektrische Isolierschicht (11) und eine erste Metallisierungsschicht (111) umfasst, die auf einer ersten Seite der dielektrischen Isolierschicht (11) angeordnet ist;
mindestens einen Halbleiterbody (20), der auf einer ersten Oberfläche (101) der ersten Metallisierungsschicht (111) montiert ist, die von der dielektrischen Isolierschicht (11) abgewandt ist;
mindestens ein Kontaktelement (22), das mit der ersten Metallisierungsschicht (111) mechanisch und elektrisch verbunden ist, wobei jedes der Kontaktelemente (22) sich von der ersten Metallisierungsschicht (111) in einer vertikalen Richtung (y) senkrecht zur ersten Oberfläche (101) erstreckt,
**dadurch gekennzeichnet, dass**
jedes Kontaktelement (22) einen ersten elektrisch leitenden Teil (221), einen zweiten elektrisch leitenden Teil (222) und eine elektrisch isolierende Schicht (23) umfasst, die zwischen dem ersten Teil (221) und dem zweiten Teil (222) angeordnet ist, um dadurch den ersten Teil (221) und den zweiten (222) miteinander zu verbinden und elektrische Verbindung zwischen dem ersten Teil (221) und dem zweiten Teil (222) zu verhindern,
jedes Kontaktelement (22) eine erste Länge (l₁) in der vertikalen Richtung (y) aufweist, die größer als seine Abmessungen (bₙ, wₙ) in einer ersten und einer zweiten horizontalen Richtung (x, z) senkrecht zur vertikalen Richtung (y) ist; und
die elektrisch isolierende Schicht (23) eines Kontaktelements (22) sich in der vertikalen Richtung (y) zwischen dem jeweiligen ersten Teil (221) und zweiten Teil (222) erstreckt.

2. Leistungshalbleitermodulanordnung nach Anspruch 1, wobei die erste Metallisierungsschicht (111) eine strukturierte Schicht ist, die mindestens zwei Abschnitte umfasst, wobei ein Spalt zwischen zwei benachbarten Abschnitten ausgebildet ist, derart dass ein direkter elektrischer Kontakt zwischen verschiedenen Abschnitten verhindert wird; und
der erste Teil (221) eines Kontaktelements (22) mit einem anderen Abschnitt der ersten Metallisierungsschicht (111) elektrisch gekoppelt ist als der zweite Teil (222) desselben Kontaktelements (22).

3. Leistungshalbleitermodulanordnung nach Anspruch 1 oder 2, wobei der erste Teil (221) eines Kontaktelements (22) und der zweite Teil (222) desselben Kontaktelements (22) mindestens eines von identischen Widerstandsverhalten, identischen Induktionsverhalten und identischen Kapazitätsverhalten aufweisen.

4. Leistungshalbleitermodulanordnung nach einem der Ansprüche 1 oder 3, wobei der erste Teil (221) eines Kontaktelements (22) und der zweite Teil (222) desselben Kontaktelements (22) identische Abmessungen, identische Querschnittsflächen und identische Materialien aufweisen.

5. Leistungshalbleitermodulanordnung nach einem der Ansprüche 1 bis 4, ferner umfassend eine gedruckte Leiterplatte (50), wobei
die gedruckte Leiterplatte (50) Durchgangslöcher (51) umfasst; und
die Kontaktelemente (22) in die Durchgangslöcher (51) der gedruckten Leiterplatte (50) eingefügt sind.

6. Leistungshalbleitermodulanordnung nach Anspruch 5, wobei
die gedruckte Leiterplatte (50) eine Leiterbahn (52) umfasst, wobei die Leiterbahn (52) mindestens zwei Abschnitte umfasst, die voneinander elektrisch isoliert sind; und
der erste Teil (221) eines Kontaktelements (22) mit einem anderen Abschnitt der Leiterbahn (52) elektrisch gekoppelt ist als der zweite Teil (222) desselben Kontaktelements (22).

7. Leistungshalbleitermodulanordnung nach einem der Ansprüche 1 bis 6, wobei jedes der Mehrzahl von Kontaktelementen (22) einen runden oder einen eckigen Querschnitt aufweist.

8. Leistungshalbleitermodulanordnung nach Anspruch 7, wobei mindestens eines der Mehrzahl von Kontaktelementen (22) ein erstes und ein zweites Stück (24, 26) umfasst, wobei das erste Stück (26) einen rohrförmigen Teil umfasst, der das zweite Stück (24) wenigstens teilweise umschließt, und wobei
ein erster Teil (261) des ersten Stücks (26) mit einem ersten Teil (241) des zweiten Stücks (24) in elektrischem Kontakt ist; und
ein zweiter Teil (262) des ersten Stücks (26) mit einem zweiten Teil (242) des zweiten Stücks (24) in elektrischem Kontakt ist.

9. Leistungshalbleitermodulanordnung nach einem der vorhergehenden Ansprüche, wobei
mindestens einer der Mehrzahl von Halbleiterbodys (20) eine Gateelektrode und eine Emitterelektrode umfasst; und
mindestens eines der Mehrzahl von Kontaktelementen (22) mit seinem ersten Teil (221) mit der Gateelektrode des Halbleiterbodys (20) und mit seinem zweiten Teil (222) mit der Emitterelektrode gekoppelt ist.

10. Leistungshalbleitermodulanordnung nach einem der vorhergehenden Ansprüche, wobei das Kontaktelement (22) mindestens eines von einem Stift, einem Draht, einem rohrförmigen Teil, einer Hülse und einem Presssitzstift umfasst.

11. Leistungshalbleitermodulanordnung nach einem der vorhergehenden Ansprüche, ferner umfassend eine Verbindungsschicht zwischen dem Kontaktelement (22) und der ersten Metallisierungsschicht (111).

12. Leistungshalbleitermodulanordnung nach Anspruch 11, wobei die Verbindungsschicht mindestens eines umfasst von
einer Lötmittelschicht;
einem elektrisch leitfähigen Kleber;
einer Schicht aus Sintermetallpulver und
einer Schweißnaht.

## Revendications

1. Agencement de module à semi-conducteur de puissance comportant :
un substrat (10) semi-conducteur comportant une couche (11) d'isolation diélectrique et une première couche (111) de métallisation agencée sur un premier côté de la couche (11) d'isolation diélectrique ;
au moins un corps (20) semi-conducteur monté sur une première surface (101) de la première couche (111) de métallisation, qui fait face dans la direction s'éloignant de la couche (11) d'isolation diélectrique ;
au moins un élément (22) de contact, qui est connecté mécaniquement et électriquement à la première couche (111) de métallisation, dans lequel chacun des éléments (22) de contact s'étend à partir de la première (111) de métallisation dans une direction (y) verticale perpendiculaire à la première surface (101), **caractérisé en ce que**
chaque élément (22) de contact comporte une première partie (221) conductrice électriquement, une deuxième partie (222) conductrice électriquement, et une couche (23) d'isolation électrique agencée entre la première partie (221) et la deuxième partie (222), pour ainsi interconnecter la première partie (221) et la deuxième partie (222) et empêcher une connexion électrique entre la première partie (221) et la deuxième partie (222),
chaque élément (22) de contact ayant une première longueur (l₁) dans la direction (y) verticale qui est grande comparée à ses dimensions (bₙ, wₙ) dans une première et deuxième directions horizontales (x, z) perpendiculaires à la direction (y) verticale ; et
la couche (23) d'isolation électrique d'un élément (22) de contact s'étend entre la première partie (221) respectivement et la deuxième partie (222) respective dans la direction (y) verticale.

2. Agencement de module à semi-conducteur de puissance suivant la revendication 1, dans lequel
la première couche (111) de métallisation est une couche structurée, comportant au moins deux sections, dans lequel un interstice est formé entre deux sections voisines de sorte qu'un contact électrique direct entre des sections différentes est empêché ; et
la première partie (221) d'un élément (22) de contact est connectée électriquement à une section de la première couche (111) de métallisation différente de la deuxième partie (222) de ce même élément (22) de contact.

3. Agencement de module à semi-conducteur de puissance suivant la revendication 1 ou 2, dans lequel la première partie (221) d'un élément (22) de contact et la deuxième partie (222) du même élément (22) de contact présentent au moins l'un d'un comportement ohmique identique, d'un comportement inductif identique et d'un comportement capacitif identique.

4. Agencement de module à semi-conducteur de puissance suivant l'une quelconque des revendications 1 à 3, dans lequel la première partie (221) d'un élément (22) de contact et la deuxième partie (222) du même élément (22) de contact ont des dimensions identiques, des aires de section transversale identiques et des matériaux identiques.

5. Agencement de module à semi-conducteur de puissance suivant l'une quelconque des revendications 1 à 4, comportant en outre une plaquette (50) à circuit imprimé, dans lequel
la plaquette (50) à circuit imprimé comporte des trous (51) de traversée ; et
les éléments (22) de contact sont insérés dans les trous (51) traversants de la plaquette (50) à circuit imprimé.

6. Agencement de module à semi-conducteur de puissance suivant la revendication 5, dans lequel
la plaquette (50) à circuit imprimé comporte une piste (52) conductrice, la piste (52) conductrice comportant au moins deux sections qui sont isolées électriquement l'une de l'autre ; et
la première partie (221) d'un élément (22) de contact est connectée électriquement à une section de la piste (52) conductrice différente de la deuxième partie (222) du même élément (22) de contact.

7. Agencement de module à semi-conducteur de puissance suivant l'une quelconque des revendications 1 à 6, dans lequel chacun de la pluralité des éléments (22) de contact a une section transversale arrondie ou en forme d'angle.

8. Agencement de module à semi-conducteur de puissance suivant la revendication 7, dans lequel au moins l'un de la pluralité d'éléments (22) de contact comporte des première et deuxième pièces (24, 26), la première pièce (26) comportant une partie tubulaire qui au moins en partie encercle la deuxième pièce (24), et dans lequel
une première partie (261) de la première pièce (26) est en contact électrique avec une première partie (241) de la deuxième pièce (24) ; et
une deuxième partie (262) de la première pièce (26) est en contact électrique avec une deuxième partie (242) de la deuxième pièce (24).

9. Agencement de module à semi-conducteur de puissance suivant l'une quelconque des revendications précédentes, dans lequel
au moins l'un de la pluralité de corps (20) à semi-conducteur comporte une électrode de grille et une électrode d'émetteur ; et
au moins l'un de la pluralité d'éléments (22) de contact est connecté à l'électrode de grille du corps (20) à semi-conducteur par sa première partie (221) et à l'électrode d'émetteur par sa deuxième partie (222).

10. Agencement de module à semi-conducteur de puissance suivant l'une quelconque des revendications précédentes, dans lequel l'élément (22) de contact comporte au moins l'un d'une broche, d'un fil, d'une partie tubulaire, d'un manchon et d'une broche à adaptation à force.

11. Agencement de module à semi-conducteur de puissance suivant l'une quelconque des revendications précédentes, comportant en outre une couche de connexion entre l'élément (22) de contact et la première couche (111) de métallisation.

12. Agencement de module à semi-conducteur de puissance suivant la revendication 11, dans lequel la couche de connexion comporte au moins l'un de
une couche de matière de soudure ;
un adhésif conducteur électriquement ;
une couche de poudre métallique frittée ; et
un cordon de soudure.
